# EUROPEAN PATENT APPLICATION

(11) **EP 4 826 994 A1**
(43) Date of publication of application: **21.10.2026**
(21) Application number: 25170540.6
(22) Date of filing: 15.04.2025
(51) Int. Cl.: H03D 7/14, H03D 7/16

(54) **RF RECEIVER DEVICE AND SIGNAL PROCESSING METHOD**

(71) Applicant: u-blox AG, 8800 Thalwil (CH)
(72) Inventor: Beamish, Norman, 8800 Thalwil (CH); McCullagh, Michael J., 8800 Thalwil (CH)
(74) Representative: Epping - Hermann - Fischer

(57) **Abstract**

A radio frequency, RF, receiver device for processing an input signal (RFIN) having a RF carrier frequency comprises a clock generation circuit (CLK), and a primary and a secondary mixer (MIX1, MIX2). The clock generation circuit (CLK) is configured to generate a local oscillator, LO, signal having a LO frequency, to generate a first complex mixing signal (LOMIX1) from the LO signal, the first complex mixing signal having a mixing frequency derived from the LO frequency, and to generate a second complex mixing signal (LOMIX2) from the LO signal, the second complex mixing signal (LOMIX2) having the mixing frequency and being phase shifted relative to the first complex mixing signal (LOMIX1) by a predefined phase shift. The mixing frequency is half or basically half of the RF carrier frequency. The primary mixer (MIX1) is configured to mix the input signal (RFIN) or an amplified version (RFIN') thereof with the first complex mixing signal (LOMIX1) to generate a primary complex output signal (OUT1). The secondary mixer (MIX2) is configured to mix the primary complex output signal (OUT1) with the second complex mixing signal (LOMIX2) to generate a secondary complex output signal (OUT2).

## Description

### TECHNICAL FIELD

This disclosure relates to a radio frequency, RF, receiver device for processing a RF input signal. The disclosure further relates to a signal processing method for processing a RF input signal.

### BACKGROUND ART

Various devices with RF signal reception, in short: radios, require some way to convert RF signals to baseband. This conversion is typically done with a mixer circuit. Since the advent of CMOS radios the passive mixer structure has been very widely used. This structure exploits the ability of CMOS circuits to be easily switched between the ON and OFF modes.

One of the most widely used passive mixer circuits is the 4-phase or 25% mixer. This circuit uses 4 phases in order to satisfy both noise performance and IQ balance. This typically requires a clock source operating at twice the carrier frequency of the RF signal being mixed to baseband. However, the higher carrier frequency usually results in a higher power consumption to generate the clock signal, which affects low power applications like battery powered devices.

### SUMMARY OF INVENTION

An object to be achieved is to provide an improved processing concept for down-converting RF signals to baseband.

This object is achieved with the subject-matter of the independent claims. Embodiments and developments derive from the dependent claims.

The improved processing concept is based on the insight that instead of using the four phases of a clock signal having twice the carrier frequency in a conventional mixer, two clock signals of lower frequency that are phase shifted relative to each other can be used to achieve the same effect by mixing the RF signal to be down-converted consecutively with the two clock signals or by mixing it with a combination of the two clock signals. The improved processing concept therefore implements a mixing operation that is mathematically identical to the widely used, traditional 25% mixing structure. Since a lower frequency is needed for the generation of the two clock signals, the improved processing concept consumes less power than the conventional 25% mixer.

For example, the two clock signals both have a mixing frequency derived from a local oscillator, LO, frequency and are phase shifted, relative to each other, by a predefined phase shift, which for example is 45° or an odd multiple of 45°. For instance, 45° correspond to an eighth of a period of the LO frequency. For example, a second complex mixing signal is a phase shifted version of a first complex mixing signal.

In an example implementation of a RF receiver device for processing an input signal having a RF carrier frequency according to the improved processing concept the receiver device comprises a clock generation circuit, and a primary and a secondary mixer. The clock generation circuit is configured to generate a LO signal having a LO frequency, to generate a first complex mixing signal from the LO signal, wherein the first complex mixing signal has a mixing frequency derived from the LO frequency, and to generate a second complex mixing signal from the LO signal, wherein the second complex mixing signal has the mixing frequency and is phase shifted relative to the first complex mixing signal by a predefined phase shift.

The primary mixer is configured to mix the input signal or an amplified version thereof with the first complex mixing signal to generate a primary complex output signal. The secondary mixer is configured to mix the primary complex output signal with the second complex mixing signal to generate a secondary complex output signal.

The mixing frequency is half or basically half of the RF carrier frequency. Basically half for example means any frequencies in a frequency range that allows reasonable down-converting of the RF signal.

If the LO frequency for example is half or basically half of the RF carrier frequency, the mixing frequency corresponds to the LO frequency. If alternatively the LO frequency has a higher frequency, e.g. the RF carrier frequency or twice the RF carrier frequency, the mixing frequency is derived from the LO frequency, e.g. by dividing the LO frequency by 2 or 4, respectively.

The primary complex output signal e.g. consists of a primary in-phase output signal and a primary quadrature output signal. Similarly, the secondary complex output signal e.g. consists of a secondary in-phase output signal and a secondary quadrature output signal.

The secondary complex output signal and its in-phase and quadrature components correspond to or are the basis for the baseband signal that can be further processed inside or outside the RF receiver device.

For example, the RF receiver device may comprise a low pass filter block configured to filter the secondary complex output signal.

In some implementations of the RF receiver device the secondary mixer is a complex mixer and comprises a first secondary mixing unit configured to mix the primary in-phase output signal with the second complex mixing signal and a second secondary mixing unit configured to mix the primary quadrature output signal with the second complex mixing signal, and is configured to generate the secondary complex output signal from outputs of the first and the second secondary mixing units.

The RF receiver device may be implemented for differential signal processing. For example, the input signal is provided to the first mixer as a differential signal. Similarly, the first and the second complex mixing signals may also be processed in a differential form, such that e.g. four signal lines are used for each of the first and the second complex mixing signal.

In some implementations the first and the second complex mixing signal are signals with two or more phases, each phase being either a quarter or half the period of the first and the second complex mixing signal. For example, a signal value may remain constant or basically constant during each of such phases.

For the first example, with four constant or basically constant signal phases, each being a quarter of the period of the first complex mixing signal, the first complex mixing signal repeating at the mixing frequency, the differential in-phase component of the first complex mixing signal may alter its value after each quarter according to a periodic signal scheme of "+1", "0", "-1", "0" etc. The corresponding quadrature component of the first complex mixing signal may be phase-shifted by one quarter or 90°, e.g. according to a periodic signal scheme of "0", "+1", "0", "-1" etc. The second complex mixing signal has the same or similar signal scheme and is phase-shifted by the predetermined phase shift relative to the first complex mixing signal.

For the second example, with two constant or basically constant signal phases, each being half of the period of the first complex mixing signal, the first complex mixing signal repeating at the mixing frequency, the differential in-phase component of the first complex mixing signal may alter its value after each half according to a periodic signal scheme of "+1" and "-1". The corresponding quadrature component of the first complex mixing signal may be phase-shifted by one quarter or 90° following the same signal scheme of "+1", and "-1". The second complex mixing signal has the same or similar signal scheme and is phase-shifted by the predetermined phase shift relative to the first complex mixing signal.

The RF receiver device may be a Global Navigation Satellite System, GNSS, receiver. For example, the RF carrier frequency for such application is in the range of one of the following ranges:
- 1571 MHz to 1579 MHz;
- 1166 MHz to 1186 MHz;
- 1245 MHz to 1255 MHz.

Furthermore, the RF receiver device could be part of a mmWave system, where clock frequencies are in the order of 28 GHz or more. Especially in this frequency range the reduction of the clock frequency that can be achieved with the improved processing concept can have a positive impact on the power consumption.

The improved processing concept can also be implemented with a signal processing method for processing a RF input signal having a RF carrier frequency. In one implementation such method comprises
- receiving a RF input signal having a RF carrier frequency;
- generating a local oscillator, LO, signal having a LO frequency;
- generating a first complex mixing signal from the LO signal, the first complex mixing signal having a mixing frequency derived from the LO frequency, wherein the mixing frequency is half or basically half of the RF carrier frequency;
- generating a second complex mixing signal from the LO signal, the second complex mixing signal having the mixing frequency and being phase shifted relative to the first complex mixing signal by a predefined phase shift; and
- mixing the input signal or an amplified version of the input signal with the first complex mixing signal and the second complex mixing signal or with a combination of the first complex mixing signal and the second complex mixing signal to generate a secondary complex output signal.

In some implementations mixing the input signal or the amplified version of the input signal to generate the secondary complex output signal comprises mixing the input signal or the amplified version of the input signal with the first complex mixing signal to generate a primary complex output signal, and mixing the primary complex output signal with the second complex mixing signal to generate the secondary complex output signal.

In some alternative implementations mixing the input signal or the amplified version of the input signal to generate the secondary complex output signal comprises generating a combined complex mixing signal by combining the first complex mixing signal with the second complex mixing signal, and mixing the input signal or the amplified version of the input signal with the combined complex mixing signal to generate the secondary complex output signal. The combined mixing signal may have a similar waveform as the conventional 25% mixing signal, but it is still derived without the need of having an oscillator signal having twice the RF carrier frequency.

For example, generating the combined complex mixing signal comprises mixing the first complex mixing signal with the second complex mixing signal.

Further details and implementations of the method become readily apparent to the skilled reader from the various implementations of the RF receiver device described in this disclosure.

### BRIEF DESCRIPTION OF DRAWINGS

The improved processing concept will be explained in more detail in the following with the aid of the drawings. Elements and functional blocks having the same or similar function bear the same reference numerals throughout the drawings. Hence their description is not necessarily repeated in the following drawings.

In the drawings:
- Figure 1: shows an example implementation of a RF receiver device;
- Figure 2: shows another example implementation of a RF receiver device;
- Figure 3: shows example timing diagrams of complex mixing signals;
- Figure 4: shows further example timing diagrams of complex mixing signals;
- Figure 5: shows another example implementation of a RF receiver device;
- Figure 6: shows another example implementation of a RF receiver device;
- Figure 7: shows an example implementation of a detail of a RF receiver device; and

- Figure 8: shows an example implementation of a signal processing method for processing a RF input signal.

### DETAILED DESCRIPTION

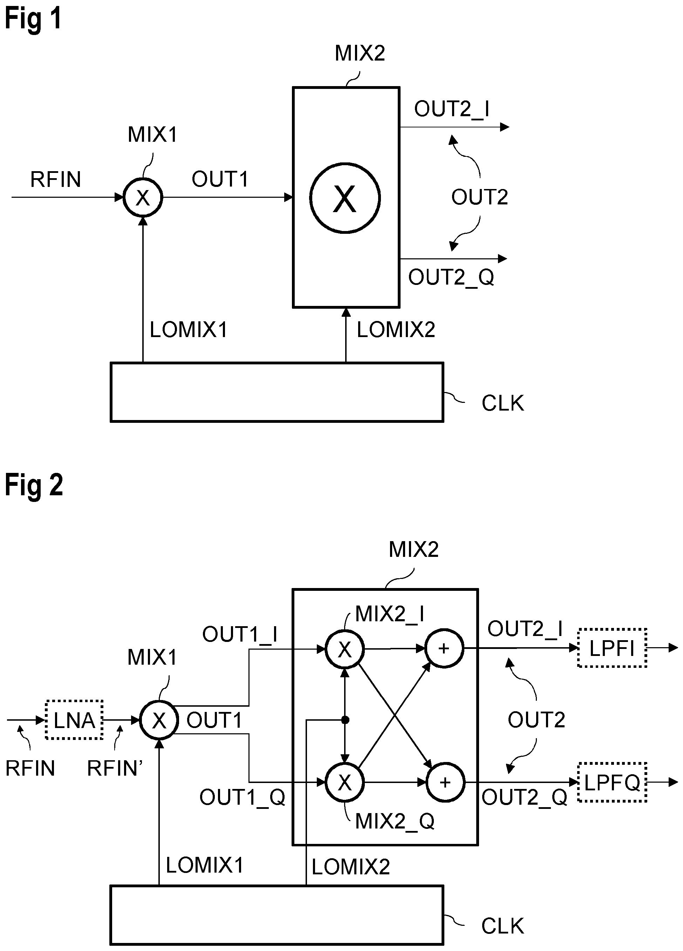

Figure 1 shows an example implementation of a RF receiver device according to the improved processing concept for processing an input signal RFIN having a RF carrier frequency. The RF receiver device comprises a primary mixer MIX1 coupled to a signal input for receiving the input signal RFIN, a secondary mixer MIX2 connected downstream to the primary mixer MIX1, and a clock generation circuit CLK that provides a first complex mixing signal LOMIX1 to the primary mixer MIX1 and a second complex mixing signal LOMIX2 to the secondary mixer MIX2.

The clock generation circuit CLK is configured to generate a LO signal having a LO frequency, which for example is half or basically half of the RF carrier frequency. The clock generation circuit CLK is further configured to generate the first complex mixing signal LOMIX1 from the LO signal such that the first complex mixing signal LOMIX1 has a mixing frequency derived from the LO frequency, and to generate the second complex mixing signal LOMIX2 from the LO signal such that the second complex mixing signal LOMIX2 also has the mixing frequency and is phase shifted relative to the first complex mixing signal LOMIX1 by a predefined phase shift. The predefined phase shift, for example, is 45° or an odd integer multiple of 45°. For instance, 45° correspond to an eighth of a period of the mixing frequency. For example, the second complex mixing signal is generated as a phase shifted version of the first complex mixing signal.

If the LO frequency for example is half or basically half of the RF carrier frequency, the mixing frequency corresponds to the LO frequency. If alternatively the LO frequency has a higher frequency, e.g. the RF carrier frequency or twice the RF carrier frequency, the mixing frequency is derived from the LO frequency, e.g. by dividing the LO frequency by 2 or 4, respectively.

In this example implementation the primary mixer MIX1 mixes the input signal RFIN with the first complex mixing signal LOMIX1 to generate a primary complex output signal OUT1, which is input to the secondary mixer MIX2. The secondary mixer MIX2 mixes the primary complex output signal OUT1 with the second complex mixing signal LOMIX2 to generate a secondary complex output signal OUT2. The secondary mixer MIX2 acts as a complex mixer by processing two complex input signals. Consequently, the secondary complex output signal OUT2 consists of a secondary in-phase output signal OUT2_I and a secondary quadrature output signal OUT2_Q. The secondary complex output signal OUT2 corresponds to a baseband signal which previously has been included in the input signal RFIN modulated by the RF carrier frequency.

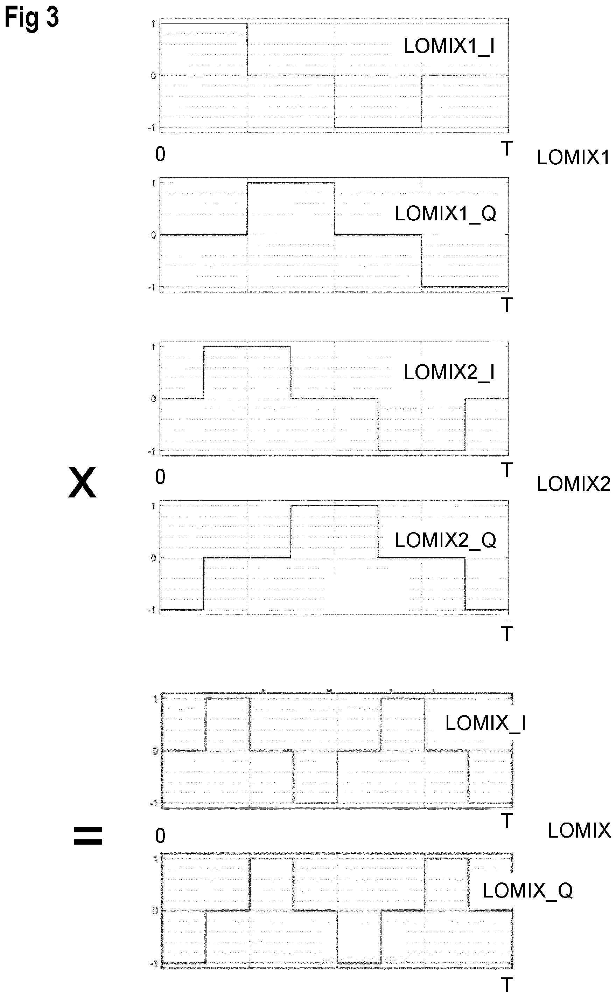

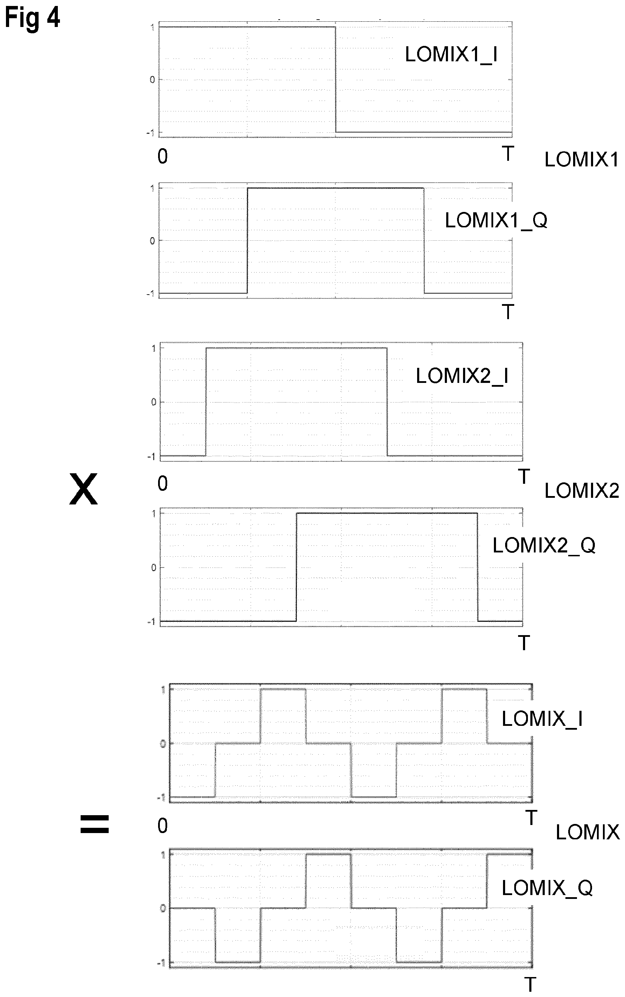

The consecutive mixing of the input signal RFIN with the two complex mixing signals LOMIX1, LOMIX2, which both have the mixing frequency that is lower than the RF carrier frequency, achieves the same down-converting as a single mixer using a mixing signal being derived from a clock signal having twice the RF carrier frequency. This will be explained in more detail below in conjunction with Figure 3 and Figure 4.

Figure 2 shows another example implementation of a RF receiver device and can be seen as a development of the implementation of Figure 1. In this implementation the input signal RFIN is first processed by an amplifier LNA, which for example is a low noise amplifier, in order to generate a derived input signal RFIN' acting as the input to the primary mixer MIX1.

The primary complex output signal OUT1 consists of a primary in-phase output signal OUT1_I and a primary quadrature output signal OUT1_Q, which both are provided to the secondary mixer MIX2. This could also be the case in the implementation of Figure 1.

The secondary complex mixer MIX2 for example comprises two secondary mixing units MIX2_I, MIX2_Q for separately mixing the primary in-phase output signal OUT1_I and the primary quadrature output signal OUT1_Q with the second complex mixing signal LOMIX2. As each of the secondary mixing units MIX2_I, MIX2_Q provides an in-phase part and a quadrature part, respectively, two adders are provided symbolically to merge these parts to the secondary in-phase output signal OUT2_I and the secondary quadrature output signal OUT2_Q, respectively.

The secondary in-phase output signal OUT2_I and the secondary quadrature output signal OUT2_Q may be further processed by respective optional low pass filters LPFI, LPFQ before further processing inside or outside the RF receiver device.

Figure 3 and Figure 4 show example timing diagrams of complex mixing signals. In both Figures the upper diagram shows the first complex mixing signal LOMIX1 with its in-phase component LOMIX1_I and its quadrature component LOMIX1_Q over one signal period T of the mixing frequency. Similarly, the middle diagrams respectively show the second complex mixing signal LOMIX2 with its in-phase component LOMIX2_I and its quadrature component LOMIX2_Q over one signal period T of the mixing frequency. The respective bottom diagrams show the result of mixing the first complex mixing signal LOMIX1 with the second complex mixing signal LOMIX2 in a complex mixing process, i.e. a combined complex mixing signal LOMIX with an in-phase component LOMIX_I and a quadrature component LOMIX_Q over one signal period T of the mixing frequency.

Referring now to Figure 3, each in-phase and quadrature component of the first and the second complex mixing signal LOMIX1, LOMIX2, has four constant or basically constant signal phases, each phase being a quarter of the period T. The differential in-phase component LOMIX1_I of the first complex mixing signal LOMIX1 alters its value after each quarter according to a periodic signal scheme of "+1", "0", "-1", "0" etc. The corresponding quadrature component LOMIX1_Q of the first complex mixing signal LOMIX1 is phase-shifted by one quarter or 90°, e.g. according to a periodic signal scheme of "0", "+1", "0", "-1" etc. The components LOMIX2_I and LOMIX2_Q of the second complex mixing signal LOMIX2 have the same signal scheme and are phase-shifted relative to the first complex mixing signal LOMIX1 by the predetermined phase shift, which in this example is 1/8 of the signal period T, or 45°, respectively. Therefore, LOMIX2_I is phase shifted 45° relative to LOMIX1_I and LOMIX2_Q is phase shifted 45° relative to LOMIX1_Q.

The resulting combined complex mixing signal LOMIX with its in-phase component LOMIX_I and its quadrature component LOMIX_Q basically corresponds to a signal form that is used in a conventional 25% mixer. However, according to the improved processing concept, the combined complex mixing signal LOMIX is achieved with a lesser clock frequency than in the conventional approach, which requires twice the RF carrier frequency. While mixing of the first and the second complex mixing signal LOMIX1, LOMIX2, indeed results in a combined complex mixing signal LOMIX that can be used for down-converting an input signal, the example diagrams also show that the consecutive mixing of the input signal RFIN with the first complex mixing signal LOMIX1 and the second complex mixing signal LOMIX2 achieves the same effect as directly mixing the input signal RFIN with the combined complex mixing signal LOMIX.

Referring now to Figure 4, each in-phase and quadrature component of the first and the second complex mixing signal LOMIX1, LOMIX2, has two constant or basically constant signal phases, each phase being half of the period T of the mixing frequency. The differential in-phase component LOMIX1_I of the first complex mixing signal LOMIX1 alters its value after each half period according to a periodic signal scheme of "+1" and "-1". The corresponding quadrature component LOMIX1_Q of the first complex mixing signal LOMIX1 is phase-shifted by one quarter or 90° following the same signal scheme of "+1", and "-1". The components LOMIX2_I and LOMIX2_Q of the second complex mixing signal LOMIX2 have the same signal scheme and are phase-shifted to the first complex mixing signal LOMIX1 by the predetermined phase shift, which also is 1/8 of the signal period T, or 45°, respectively, in this example. Therefore, LOMIX2_I is phase shifted 45° relative to LOMIX1_I and LOMIX2_Q is phase shifted 45° relative to LOMIX1_Q.

As in the example of Figure 3, the resulting combined complex mixing signal LOMIX with its in-phase component LOMIX_I and its quadrature component LOMIX_Q basically corresponds to a signal form that is used in a conventional 25% mixer. However, as less signal phases are used in this example compared to the implementation of Figure 3, less switching is required in the corresponding mixers. This can further reduce power consumption.

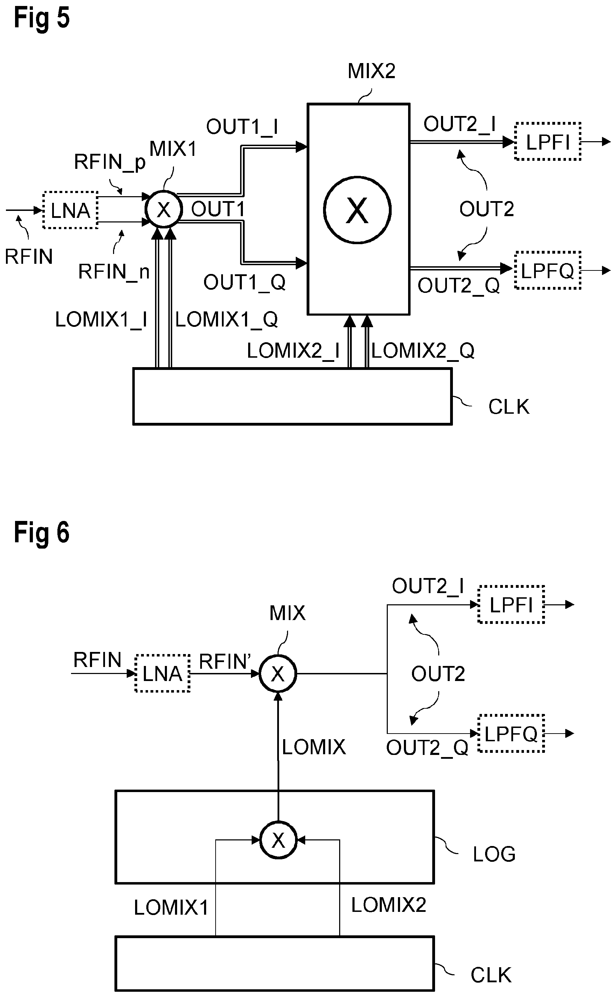

Figure 5 shows another example implementation of a RF receiver device, and can be seen as a development of the implementations of Figure 1 or Figure 2. In this implementation the RF receiver device is implemented for differential signal processing. For example, the double lined arrows in Figure 5 denote differential signals. In other words, each of the signals LOMIX1_I, LOMIX1_Q, LOMIX2_I. LOMIX2_Q, OUT1_I, OUT1_Q, OUT2_I, OUT2_Q is generated and processed as a differential signal in this implementation.

As in the example implementation of Figure 2, the input signal RFIN is also first processed by the amplifier LNA, which outputs the processed input signal in differential form with a first portion RFIN_p of positive polarity and a second portion of negative polarity RFIN_n. The further processing with the primary mixer MIX1 and the secondary mixer MIX2 corresponds to that of the previously described implementations.

Figure 6 shows an alternative example implementation of a RF receiver device. In this implementation the RF receiver device comprises a single mixer MIX that is provided with the derived input signal RFIN' and the combined complex mixing signal LOMIX. The combined complex mixing signal LOMIX is generated by a logic block LOG from the first complex mixing signal LOMIX1 and the second complex mixing signal LOMIX2. For example, the process performed in the logic block LOG corresponds to that described in conjunction with Figure 3 and Figure 4. The mixer MIX outputs the secondary complex output signal OUT2 consisting of a secondary in-phase output signal OUT2_I and a secondary quadrature output signal OUT2_Q. All of the mentioned signals can be differential signals.

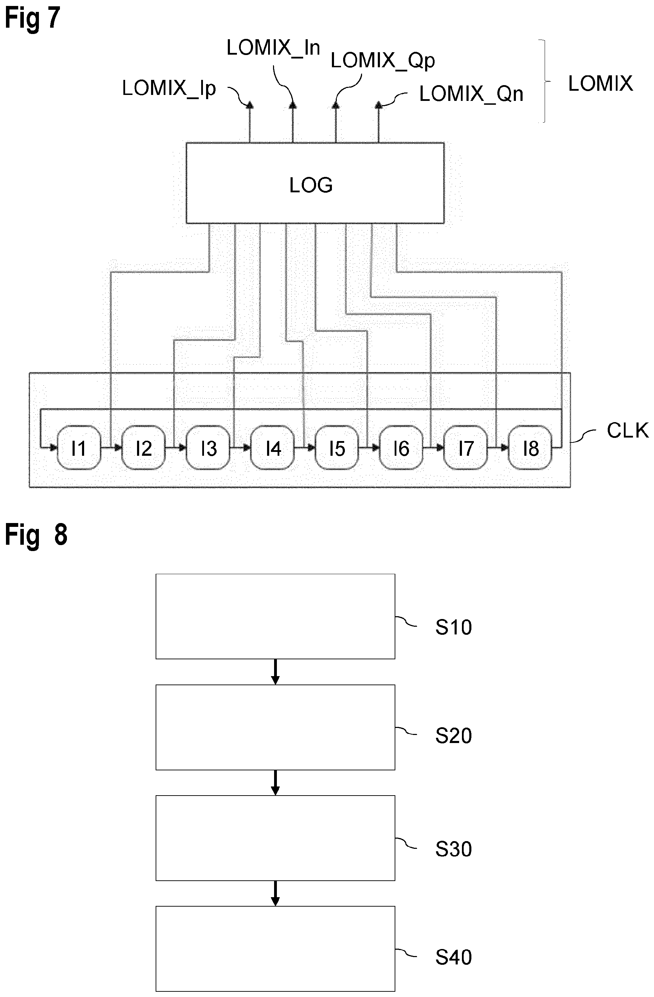

Figure 7 shows an example implementation of a detail of a RF receiver device that, for example, can be applied in the implementation of Figure 8. The clock generation circuit CLK is formed as an 8-phase ring oscillator with eight consecutively coupled inverters I1-I8 with the feedback from the eighth inverter I8 to the first inverter I1. Each of the inverters provides a phase shift of an eighth of the total signal period T. The respective outputs are provided to the logic block LOG which includes Boolean elements like AND, NOT, OR to provide their respective differential signal components LOMIX_Ip, LOMIX_In, LOMIX_Qp, LOMIX_Qn of the differential combined complex mixing signal LOMIX. The 8-phase ring oscillator operates at half the RF carrier frequency.

A clock generation circuit CLK with an 8-phase ring oscillator can also be used to generate the first and the second complex mixing signal LOMIX1, LOMIX2 in differential form.

Figure 8 shows an example implementation of a signal processing method for processing a RF input signal according to the improved processing concept.

A step S10 includes receiving a RF input signal having a RF carrier frequency, e.g. signal RFIN.

A step S20 includes generating a local oscillator, LO, signal having a LO frequency, e.g. by the clock generation circuit CLK.

A step S30 includes generating a first complex mixing signal from the LO signal, the first complex mixing signal having a mixing frequency derived from the LO frequency. Step S30 further includes generating a second complex mixing signal from the LO signal, the second complex mixing signal having the mixing frequency and being phase shifted to the first complex mixing signal by a predefined phase shift. These may be the signals LOMIX1 and LOMIX2. The predefined phase shift, for example, is 45° or an odd multiple of 45°. For instance, 45° correspond to an eighth of a period of the mixing frequency. As described in the previous implementations, the mixing frequency is half or basically half of the RF carrier frequency.

A step S40 includes mixing the input signal or an amplified version of the input signal with the first complex mixing signal and the second complex mixing signal or with a combination of the first complex mixing signal and the second complex mixing signal to generate a secondary complex output signal.

For example, step S40 may include mixing the input signal, e.g. signal RFIN, or the amplified version of the input signal with the first complex mixing signal, e.g. signal LOMIX1, to generate a primary complex output signal, e.g. signal OUT1, and mixing the primary complex output signal with the second complex mixing signal, e.g. signal LOMIX2, to generate the secondary complex output signal, e.g. signal OUT2.

In some alternative implementations step S40 includes generating a combined complex mixing signal, e.g. signal LOMIX, by combining the first complex mixing signal with the second complex mixing signal, and mixing the input signal or the amplified version of the input signal with the combined complex mixing signal to generate the secondary complex output signal. For example, generating the combined complex mixing signal comprises mixing the first complex mixing signal with the second complex mixing signal.

Various embodiments of the improved processing concept can be implemented in the form of logic in software or hardware or a combination of both. The logic may be stored in a computer readable or machine-readable storage medium as a set of instructions adapted to direct one or more processors of a computer system to perform a set of steps disclosed in embodiments of the improved processing concept. The logic may form part of a computer program product adapted to direct an information-processing device to automatically perform a set of steps disclosed in embodiments of the improved processing concept.

The specification and drawings are, accordingly, to be regarded in an illustrative rather than a restrictive sense. However, it will be evident that various modifications and changes may be made thereunto without departing from the scope of the invention as set forth in the claims.

### LIST OF REFERENCE SIGNS

- RFIN, RFIN': input signal
- LOMIX1, LOMIX2: complex mixing signal
- LOMIX1_I, LOMIX2_I: in-phase component
- LOMIX1_Q, LOMIX2_Q: quadrature component
- LOMIX: complex mixing signal
- LOMIX_I, LOMIX_I: in-phase component
- LOMIX_Q, LOMIX_Q: quadrature component
- OUT1, OUT2: complex output signal
- OUT1_I, OUT2_I: in-phase component
- OUT1_Q, OUT2_Q: quadrature component
- MIX1, MIX2: mixer
- MIX2_I, MIX2_Q: mixer
- T: signal period
- CLK: clock generation circuit
- LNA: amplifier
- LPFI, LPFQ: filter
- LOG: logic block
- S10 - S40: method steps

## Claims

1. A radio frequency, RF, receiver device for processing an input signal (RFIN) having a RF carrier frequency, the RF receiver device comprising
- a clock generation circuit (CLK) being configured to
- generate a local oscillator, LO, signal having a LO frequency;
- generate a first complex mixing signal (LOMIX1) from the LO signal, the first complex mixing signal having a mixing frequency derived from the LO frequency, wherein the mixing frequency is half or basically half of the RF carrier frequency; and
- generate a second complex mixing signal (LOMIX2) from the LO signal, the second complex mixing signal (LOMIX2) having the mixing frequency and being phase shifted relative to the first complex mixing signal (LOMIX1) by a predefined phase shift, in particular by 45°;
- a primary mixer (MIX1) configured to mix the input signal (RFIN) or an amplified version (RFIN') of the input signal with the first complex mixing signal (LOMIX1) to generate a primary complex output signal (OUT1); and
- a secondary mixer (MIX2) configured to mix the primary complex output signal (OUT1) with the second complex mixing signal (LOMIX2) to generate a secondary complex output signal (OUT2).

2. The RF receiver device according to claim 1, wherein
- the primary complex output signal (OUT1) consists of a primary in-phase output signal (OUT1_I) and a primary quadrature output signal (OUT1_Q); and
- the secondary mixer (MIX2) is a complex mixer, comprises a first secondary mixing unit (MIX2_I) configured to mix the primary in-phase output signal (OUT1_I) with the second complex mixing signal (LOMIX2) and a second secondary mixing unit configured to mix the primary quadrature output signal (OUT1_Q) with the second complex mixing signal(LOMIX2), and is configured to generate the secondary complex output signal (OUT2) from outputs of the first and the second secondary mixing unit.

3. The RF receiver device according to claim 1 or 2, wherein the second complex mixing signal (LOMIX2) is a phase shifted version of the first complex mixing signal (LOMIX1).

4. The RF receiver device according to one of claims 1 to 3, wherein the first and the second complex mixing signal are signals with two or more signal phases, and wherein each phase is a quarter of the period of the first and the second complex mixing signal or half of the period of the first and the second complex mixing signal.

5. The RF receiver device according to one of claims 1 to 4, wherein the first and the second complex mixing signal are differential signals.

6. The RF receiver device according to one of claims 1 to 5, wherein the input signal is a differential signal.

7. The RF receiver device according to one of claims 1 to 6, further comprising a lowpass filter block configured to filter the secondary complex output signal (OUT2).

8. The RF receiver device according to one of claims 1 to 7, wherein the RF receiver device is a Global Navigation Satellite System, GNSS, receiver.

9. A signal processing method for processing a radio frequency, RF, input signal (RFIN) having a RF carrier frequency, the method comprising
- receiving a RF input signal (RFIN) having a RF carrier frequency;
- generating a local oscillator, LO, signal having a LO frequency;
- generating a first complex mixing signal (LOMIX1) from the LO signal, the first complex mixing signal (LOMIX1) having a mixing frequency derived from the LO frequency, wherein the mixing frequency is half or basically half of the RF carrier frequency;
- generating a second complex mixing signal (LOMIX2) from the LO signal, the second complex mixing signal (LOMIX2) having the mixing frequency and being phase shifted relative to the first complex mixing signal (LOMIX1) by a predefined phase shift, in particular by 45°; and
- mixing the input signal (RFIN) or an amplified version (RFIN') of the input signal with the first complex mixing signal (LOMIX1) and the second complex mixing signal (LOMIX2) or with a combination of the first complex mixing signal (LOMIX1) and the second complex mixing signal (LOMIX1) to generate a secondary complex output signal (OUT2).

10. The method according to claim 9, wherein mixing the input signal or the amplified version of the input signal to generate the secondary complex output signal comprises:
- mixing the input signal or the amplified version of the input signal with the first complex mixing signal (LOMIX1) to generate a primary complex output signal (OUT1); and
- mixing the primary complex output signal (OUT1) with the second complex mixing signal (LOMIX2) to generate the secondary complex output signal (OUT2).

11. The method according to claim 9 or 10, wherein mixing the input signal or the amplified version of the input signal to generate the secondary complex output signal comprises:
- generating a combined complex mixing signal (LOMIX) by combining the first complex mixing signal (LOMIX1) with the second complex mixing signal (LOMIX2); and
- mixing the input signal or the amplified version of the input signal with the combined complex mixing signal to generate the secondary complex output signal.

12. The method according to claim 11, wherein generating the combined complex mixing signal comprises mixing the first complex mixing signal with the second complex mixing signal.
